# FASCICULE DE BREVET EUROPEEN

(11) **EP 3 740 773 B1**
(45) Date de publication et mention de la délivrance du brevet: **17.05.2023**
(21) Numéro de dépôt: 19700507.7
(22) Date de dépôt: 15.01.2019
(51) Int. Cl.: G01R 31/36, G01R 31/367, G01R 31/396, H01M 10/48

(54) **PROCEDE DE DETECTION D'UNE CELLULE DEFAILLANTE DANS UNE BATTERIE ELECTRIQUE**
VERFAHREN ZUR ERKENNUNG EINER FEHLERHAFTEN ZELLE IN EINER ELEKTRISCHEN BATTERIE
METHOD FOR DETECTING A FAULTY CELL IN AN ELECTRIC BATTERY

(30) Priorité: 16.01.2018 FR 1850345
(43) Date de publication de la demande: 25.11.2020
(73) Titulaire: Renault s.a.s, 92100 Boulogne Billancourt (FR); Nissan Motor Co., Ltd., Yokohama-shi, Kanagawa 221-0023 (JP)
(72) Inventeur: DELOBEL, Bruno, 92130 Issy Les Moulineaux (FR); ORIGUCHI, Masato, 78120 Rambouillet (FR); ARSAC, Benoit, 78000 Versailles (FR)
(74) Mandataire: Renault Group
(86) Numéro de dépôt international: PCT/EP2019/050970
(87) Numéro de publication internationale: WO 2019/141688

(56) Documents cités:
- EP-A1- 2 518 522
- WO-A1-2015/037292
- JP-A- 2002 010 511
- US-A1- 2002 011 820
- US-A1- 2004 001 996
- US-A1- 2008 180 061
- US-A1- 2011 084 702

## Description

L'invention a pour objet un procédé de détection d'une cellule défaillante dans une batterie électrique.

Actuellement, il existe un diagnostic qui permet de protéger un pack batterie qui présente un déséquilibre contre des cellules défaillantes. Un tel diagnostic est décrit dans le brevet US2002/011820.

Cependant, ce déséquilibre n'est pas forcément dû à une cellule défaillante mais tout simplement à une dispersion de l'autodécharge.

En effet, ce diagnostic consiste généralement en une mesure de la tension afin d'estimer la différence de SOC (de l'anglais *State Of Charge*) entre la cellule la plus chargée et celle la moins chargée. Ainsi, si cette différence est supérieure à une valeur seuil prédéterminée, il sera interdit de recharger le véhicule. Le véhicule, une fois déchargé, sera donc immobilisé et devra être rapatrié en concession afin d'être réparé. Cependant, comme nous avons pu le montrer, il est possible d'avoir une dispersion d'autodécharge « naturelle », intrinsèque à une technologie ou à un lot de production, qui pourrait laisser penser à tort que le pack batterie comporte au moins une cellule défaillante. Ainsi, si un client n'utilise que très peu son véhicule, il ne bénéficie pas d'un temps important d'équilibrage des cellules. Dans cette situation, un client pourra avoir un pack batterie complètement fonctionnel, mais qui, après un certain temps, ne pourra plus être chargé, car il sera diagnostiqué comme défaillant puisque la différence de SOC entre la cellule possédant le SOC minimum et la cellule possédant le SOC maximum sera supérieure à la valeur seuil prédéterminée.

Dans le but de détecter des cellules inaptes à un usage donné ou en fin de vie, et donc de ne pas les retenir pour l'usage donné, le brevet US8332342 divulgue une méthode dans laquelle on modélise mathématiquement le comportement électrochimique interne d'une cellule lorsqu'elle débite le courant de décharge pour l'usage donné, puis on en déduit son SOC et son voltage terminal théoriques après ledit usage. Ainsi, en fonction du SOC et du voltage terminal théoriques, la cellule est retenue pour l'usage donné ou pas.

Le procédé décrit dans ce document présente l'inconvénient d'être très complexe à mettre en oeuvre, car il demande une connaissance très fine de l'électrochimie de la cellule et des capacités de calcul très élevées.

Ainsi, les procédés actuels sont soit insuffisamment performants pour distinguer une réelle défaillance d'une décharge naturelle, soit très complexes à mettre en oeuvre.

Un procédé de détection selon l'invention permet de détecter de façon sûre, simple et fiable une cellule défaillante dans un pack de batterie, en s'affranchissant des inconvénients relevés dans l'état de la technique, notamment en ne confondant pas avec l'autodécharge naturelle.

L'invention a pour objet un procédé de détection d'une cellule défectueuse dans un pack de batterie électrique.

La principale caractéristique d'un procédé selon l'invention est qu'il comprend les étapes suivantes :
- Une étape de mesure de la tension à vide aux bornes de chaque cellule du pack de batterie,
- Une étape de calcul de l'écart entre la tension à vide mesurée aux bornes de ladite cellule et une tension à vide moyenne connue en fonction du nombre de jours de non utilisation du pack de batterie,
- Une étape de calcul de la différence entre ledit écart calculé et une grandeur n.σ où n est un nombre entier supérieur ou égal à un, et σ est un écart-type connu qui est fonction du nombre de jours de non utilisation du pack de batterie,
- Une étape de détection d'une cellule défectueuse si ladite différence est supérieure à zéro.

Ce procédé permet ainsi de tester individuellement chacune des cellules constituant le pack de batterie afin de détecter une réelle défaillance d'au moins l'une des cellules. Il s'appuie sur une comparaison d'un écart calculé entre une mesure de tension à vide d'une cellule et une tension à vide moyenne que devrait présenter chaque cellule en fonction du nombre de jours de non utilisation de la batterie, avec une grandeur proportionnelle à l'écart-type. De cette manière, les critères retenus pour établir un diagnostic de défaillance réelle d'une cellule, sont plus complets et plus précis qu'une simple évaluation d'une dispersion des états de charge des cellules constituant le pack de batterie. Préférentiellement, un tel procédé est réalisé dans un véhicule automobile au moyen d'un calculateur. De façon avantageuse, un conducteur est informé de la présence d'au moins une cellule défaillante dans le pack de batterie grâce à un procédé selon l'invention, lors du démarrage de son véhicule. Les termes « défaillante » et « défectueuse » attribués à une cellule, sont équivalents.

Avantageusement, n est un nombre entier compris entre 2 et 10.

De façon préférentielle, un procédé selon l'invention comprend une étape d'alerte lorsqu'une cellule défectueuse est détectée. En effet, si une cellule défectueuse est détectée, des moyens sont mis en oeuvre afin d'empêcher le rechargement de la batterie. Il est important que le conducteur du véhicule soit informé d'une telle défaillance, afin de prendre le plus tôt possible les mesures nécessaires.

Préférentiellement, l'étape d'alerte met en oeuvre un signal visuel, visible par un individu mettant en oeuvre le procédé. De façon avantageuse, le signal visuel est réalisé au moyen d'un voyant spécifique, activé au niveau d'un écran d'une planche de bord du véhicule.

De façon avantageuse, l'étape d'alerte met en oeuvre un signal sonore, audible par un individu mettant en oeuvre le procédé.

Avantageusement, un procédé de détection selon l'invention, met en oeuvre une étape empêchant la recharge du pack de batterie lorsqu'au moins une cellule défectueuse est détectée. De cette manière, dès qu'une cellule défectueuse est détectée, la batterie ne peut plus être rechargée, obligeant un utilisateur à aller chez un professionnel pour remplacer la cellule défectueuse.

De façon préférentielle, si σ≥5mV, alors n= 6.

Préférentiellement, si σ≥ 10mV, alors n= 4.

De façon avantageuse, si σ≥20mV, alors n= 3.

Avantageusement, un procédé de détection selon l'invention comprend une étape d'affichage d'une perte d'autonomie dans le cas d'une détection d'une cellule défectueuse. Ainsi, lorsqu'une cellule est défaillante, cela se traduit par une baisse de l'autonomie du véhicule, et le conducteur du véhicule en est immédiatement informé.

Un procédé de détection selon l'invention présente l'avantage de détecter de façon sûre et fiable, une réelle défaillance d'une cellule d'un pack de batterie, en écartant notamment les configurations pour lesquelles certaines cellules se déchargent naturellement avec le temps, plus rapidement que les autres.

On donne, ci-après, une description détaillée d'un mode de réalisation préféré d'un procédé de détection selon l'invention, en se référant aux figures suivantes :
- La figure 1 est un logigramme illustrant les principales étapes d'un procédé de détection d'une cellule défectueuse selon l'état de la technique,
- La figure 2 est un logigramme illustrant les principales étapes d'un procédé de détection d'une cellule défectueuse selon l'invention,
- La figure 3 est un diagramme illustrant un premier exemple d'une répartition de cellules fonctionnelles d'un pack de batterie en fonction d'une tension à vide mesurée,
- La figure 4 est un diagramme illustrant un deuxième exemple d'une répartition de cellules fonctionnelles d'un pack de batterie en fonction d'une tension à vide mesurée,
- La figure 5 est un diagramme illustrant un troisième exemple d'une répartition de cellules fonctionnelles d'un pack de batterie en fonction d'une tension à vide mesurée, montrant une cellule défectueuse.

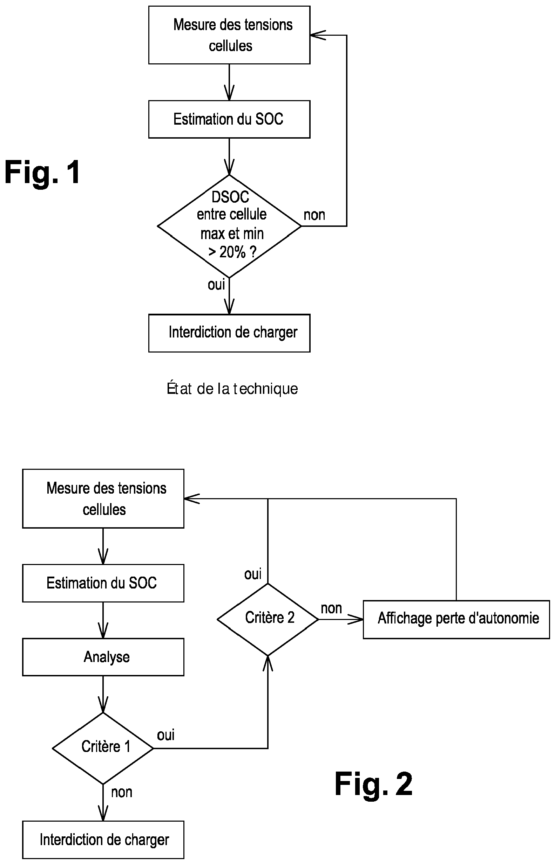

En se référant à la figure 1, un procédé de l'état de la technique, permettant de détecter une cellule électrique défaillante d'un pack de batterie, comprend :
- Une étape de mesure de la tension aux bornes de chaque cellule du pack de batterie,
- Une étape d'estimation du SOC de chacune desdites cellules,
- Une étape de détermination de la différence de SOC entre la cellule la plus chargée et la cellule la moins chargée,
- Une étape de détection d'une cellule défaillante si cette différence est supérieure ou égale à une valeur prédéterminée, pouvant par exemple être égale à 20% ou 30%.

Généralement, la détection d'au moins une cellule défaillante dans le pack de batterie s'accompagne d'une étape d'interdiction de charge dudit pack, car en raison de la présence d'au moins une cellule défaillante, ce pack est jugé non opérationnel. Avant de pouvoir le recharger, il faut donc procéder au remplacement de chaque cellule défaillante par une cellule neuve dotée de toutes ses capacités. Or, un tel procédé est assez limité, car il ne prend pas en compte une décharge naturelle d'une cellule de batterie au cours du temps, dans le cas par exemple d'une non utilisation prolongée du véhicule. Autrement dit, ce procédé n'est pas en mesure de différencier de façon indiscutable, une cellule défaillante et une cellule valide mais déchargée.

Un procédé de détection selon l'invention présente des caractéristiques permettant de distinguer de façon sûre et certaine une cellule défaillante d'une cellule saine mais déchargée.

De cette manière, en se référant à la figure 2, un procédé de détection d'une cellule défaillante dans un pack de batterie selon l'invention, comprend les étapes suivantes :
- Une étape de mesure de la tension à vide aux bornes de chaque cellule du pack de batterie,
- Une étape de calcul de l'écart entre la tension à vide mesurée aux bornes de ladite cellule et une tension à vide moyenne connue en fonction du nombre de jours de non utilisation de la batterie,
- Une étape de calcul de la différence entre ledit écart calculé et la grandeur n.σ où n est un nombre entier supérieur ou égal à un, et σ est un écart-type connu qui est fonction du nombre de jours de non utilisation de la batterie,
- Une étape de détection d'une cellule défectueuse si ladite différence est supérieure à zéro.

Contrairement au procédé de l'état de la technique décrit ci-avant, un procédé selon l'invention propose une approche plus réaliste, en intégrant le phénomène de perte de charge naturelle d'une cellule, lorsque le pack de batterie n'est pas utilisé pendant un certain nombre de jours. De cette manière, cette perte de charge naturelle ne sera plus susceptible de biaiser les conditions de détection d'une cellule défaillante.

La grandeur n.σ est ajustable en fonction de la valeur de l'écart-type σ. De cette manière, à titre d'exemples présentant de nombreux avantages,
> Si σ > 5mV alors n peut être fixé à 6,
> Si σ > 10mV alors n peut être fixé à 4,
> Si σ > 20mV alors n peut être fixé à 3,

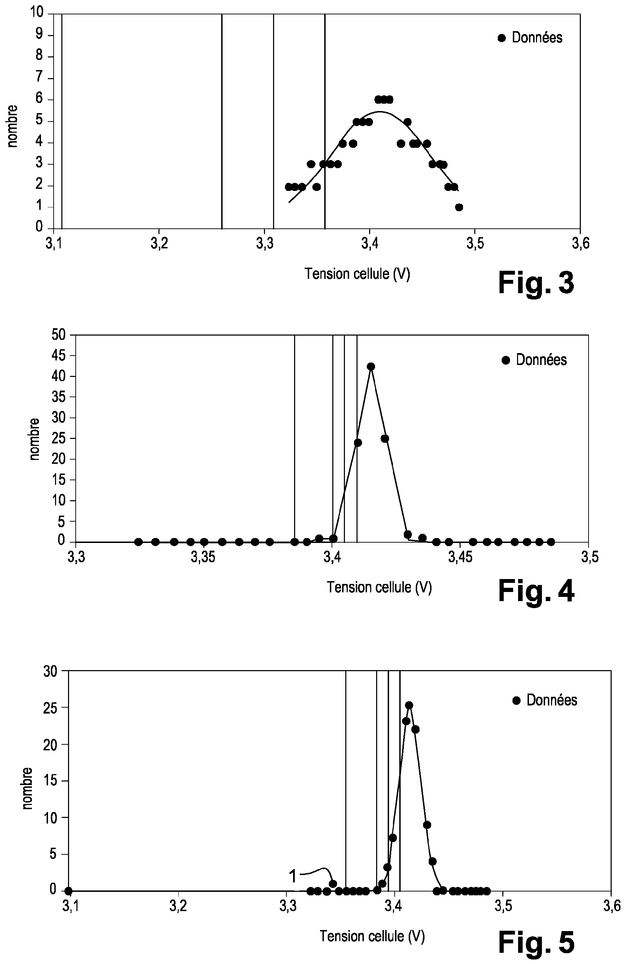

La figure 3 illustre un premier exemple de répartition des cellules d'un pack de batterie, en fonction de la tension à vide mesurée aux bornes de chacune desdites cellules. Autrement dit, chaque point représente le nombre de cellules ayant la même tension à vide mesurée. Il peut être observé que lorsqu'aucune des cellules n'est défaillante, tous les points sont organisés autour d'une gaussienne moyenne. La variation des tensions mesurées et donc des états de charge entre les cellules, est due à un phénomène d'autodécharge plus ou moins marqué d'une cellule à l'autre.

La figure 4 illustre un deuxième exemple de répartition des cellules d'un pack de batterie, en fonction de la tension à vide mesurée aux bornes de chacune desdites cellules. Tous les points sont cohérents car ils permettent de définir une courbe de répartition qui est continue et régulière, sans mettre en relief un point singulier qui sortirait de cette courbe. Le pack de batterie dont sont issues toutes ces mesures de tension, ne possède donc aucune cellule électrique défaillante.

La figure 5 illustre un troisième exemple de répartition des cellules d'un pack de batterie, en fonction de la tension à vide mesurée aux bornes de chacune desdites cellules. Contrairement à la courbe régulière illustrée à la figure 4, le diagramme de la figure 5 fait apparaitre un point 1 singulier, situé légèrement en dehors de la courbe matérialisant la répartition des cellules en fonction de la tension à vide mesurée aux bornes desdites cellules. Ce point reflète la présence d'une cellule du pack de batterie, qui est réellement défaillante. Dans ces conditions, la batterie est immobilisée et il n'est plus possible de la recharger.

Un procédé de détection selon l'invention est mis en oeuvre dans un véhicule équipé d'une batterie électrique, au moyen d'un ordinateur embarqué possédant les logiciels adaptés, et de différents équipements permettant de mesurer des tensions électriques aux bornes de chaque cellule. De cette manière, lorsque le conducteur met le contact, il est immédiatement et directement informé de l'état de sa batterie.

A ce sujet, une fois la présence d'au moins une cellule défaillante détectée, un procédé de détection selon l'invention met en oeuvre une étape d'alerte permettant au conducteur d'être informé de la présence d'une cellule défaillante. Cette étape d'alerte peut être réalisée par exemple, par le biais d'un voyant luminant apparaissant au niveau d'un tableau de bord, ou d'un signal sonore caractéristique.

Un procédé de détection selon l'invention peut également mettre en oeuvre une étape de blocage automatique de la recharge de la batterie, dans le cas où au moins une cellule électrique de ladite batterie s'avérait être défaillante et n'était pas remplacée.

## Revendications

1. Procédé de détection d'une cellule défectueuse dans un pack de batterie électrique, **caractérisé en ce qu'**il comprend les étapes suivantes :
- Une étape de mesure de la tension à vide aux bornes de chaque cellule du pack de batterie,
- Une étape de calcul de l'écart entre la tension à vide mesurée aux bornes de ladite cellule et une tension à vide moyenne connue en fonction du nombre de jours de non utilisation du pack de batterie,
- Une étape de calcul de la différence entre ledit écart calculé et une grandeur n.σ où n est un nombre entier supérieur ou égal à un, et σ est un écart-type connu qui est fonction du nombre de jours de non utilisation du pack de batterie,
- Une étape de détection d'une cellule défectueuse si ladite différence est supérieure à zéro.

2. Procédé de détection selon la revendication 1, **caractérisé en ce que** n est un nombre entier compris entre 2 et 10.

3. Procédé selon l'une quelconque des revendications 1 ou 2, **caractérisé en ce qu'**il comprend une étape d'alerte lorsqu'une cellule défectueuse est détectée.

4. Procédé selon la revendication 3, **caractérisé en ce que** l'étape d'alerte met en oeuvre un signal visuel, visible par un individu mettant en oeuvre le procédé.

5. Procédé selon la revendication 3, **caractérisé en ce que** l'étape d'alerte met en oeuvre un signal sonore, audible par un individu mettant en oeuvre le procédé.

6. Procédé selon l'une quelconque des revendications 1 à 5, **caractérisé en ce qu'**il met en oeuvre une étape empêchant la recharge du pack de batterie lorsqu'au moins une cellule défectueuse est détectée.

7. Procédé selon l'une quelconque des revendications 1 à 6, **caractérisé en ce que**, si σ≥5mV, alors n= 6.

8. Procédé selon l'une quelconque des revendications 1 à 6, **caractérisé en ce que**, si σ≥10mV, alors n= 4.

9. Procédé selon l'une quelconque des revendications 1 à 6, **caractérisé en ce que**, si σ≥20mV, alors n= 3.

10. Procédé selon l'une quelconque des revendications 1 à 9, **caractérisé en ce qu'**il comprend une étape d'affichage d'une perte d'autonomie dans le cas d'une détection d'une cellule défectueuse.

## Patentansprüche

1. Verfahren zur Erkennung einer fehlerhaften Zelle in einem elektrischen Batteriepack, **dadurch gekennzeichnet, dass** es die folgenden Schritte enthält:
- einen Schritt der Messung der Leerlaufspannung an den Klemmen jeder Zelle des Batteriepacks,
- einen Schritt der Berechnung der Abweichung zwischen der an den Klemmen der Zelle gemessenen Leerlaufspannung und einer bekannten mittleren Leerlaufspannung abhängig von der Anzahl von Tagen der Nichtbenutzung des Batteriepacks,
- einen Schritt der Berechnung der Differenz zwischen der berechneten Abweichung und einer Größe n.σ, wobei n eine ganze Zahl größer als oder gleich Eins ist, und σ eine bekannte Standardabweichung ist, die von der Anzahl von Tagen der Nichtbenutzung des Batteriepacks abhängt,
- einen Schritt der Erkennung einer fehlerhaften Zelle, wenn die Differenz höher als Null ist.

2. Verfahren nach Anspruch 1, **dadurch gekennzeichnet, dass** n eine ganze Zahl zwischen 2 und 10 ist.

3. Verfahren nach einem der Ansprüche 1 oder 2, **dadurch gekennzeichnet, dass** es einen Alarmschritt enthält, wenn eine fehlerhafte Zelle erkannt wird.

4. Verfahren nach Anspruch 3, **dadurch gekennzeichnet, dass** der Alarmschritt ein optisches Signal anwendet, das für eine das Verfahren anwendende Person sichtbar ist.

5. Verfahren nach Anspruch 3, **dadurch gekennzeichnet, dass** der Alarmschritt ein akustisches Signal anwendet, das für eine das Verfahren anwendende Person hörbar ist.

6. Verfahren nach einem der Ansprüche 1 bis 5, **dadurch gekennzeichnet, dass** es einen Schritt durchführt, der das Aufladen des Batteriepacks verhindert, wenn mindestens eine fehlerhafte Zelle erkannt wird.

7. Verfahren nach einem der Ansprüche 1 bis 6, **dadurch gekennzeichnet, dass**, wenn σ ≥ 5mV, gilt n = 6.

8. Verfahren nach einem der Ansprüche 1 bis 6, **dadurch gekennzeichnet, dass**, wenn σ ≥ 10mV, gilt n = 4.

9. Verfahren nach einem der Ansprüche 1 bis 6, **dadurch gekennzeichnet, dass**, wenn σ ≥ 20mV, gilt n = 3.

10. Verfahren nach einem der Ansprüche 1 bis 9, **dadurch gekennzeichnet, dass** es einen Schritt der Anzeige eines Autonomieverlusts im Fall einer Erkennung einer fehlerhaften Zelle enthält.

## Claims

1. Method for detecting a defective cell in an electric battery pack, **characterized in that** it comprises the following steps:
- a step of measuring the no-load voltage across the terminals of each cell of the battery pack,
- a step of calculating the deviation between the no-load voltage measured across the terminals of said cell and an average no-load voltage known depending on the number of days of lack of use of the battery pack,
- a step of calculating the difference between said calculated deviation and a variable n.σ, where n is an integer greater than or equal to one, and σ is a known standard deviation that depends on the number of days of lack of use of the battery pack,
- a step of detecting a defective cell if said difference is greater than zero.

2. Detection method according to Claim 1, **characterized in that** n is an integer between 2 and 10.

3. Method according to either one of Claims 1 and 2, **characterized in that** it comprises a warning step when a defective cell is detected.

4. Method according to Claim 3, **characterized in that** the warning step uses a visual signal visible to a person implementing the method.

5. Method according to Claim 3, **characterized in that** the warning step uses an audio signal audible to a person implementing the method.

6. Method according to any one of Claims 1 to 5, **characterized in that** it implements a step preventing the battery pack from being recharged when at least one defective cell is detected.

7. Method according to any one of Claims 1 to 6, **characterized in that**, if σ ≥ 5 mV, then n = 6.

8. Method according to any one of Claims 1 to 6, **characterized in that**, if σ ≥ 10 mV, then n = 4.

9. Method according to any one of Claims 1 to 6, **characterized in that**, if σ ≥ 20 mV, then n = 3.

10. Method according to any one of Claims 1 to 9, **characterized in that** it comprises a step of displaying a loss of autonomy in the event of detecting a defective cell.
